# EUROPEAN PATENT APPLICATION

(11) **EP 4 788 073 A1**
(43) Date of publication of application: **05.08.2026**
(21) Application number: 24872874.3
(22) Date of filing: 25.09.2024
(51) Int. Cl.: H05K 7/20, F21V 29/51, F28D 15/02

(54) **HEAT DISSIPATION DEVICE**

(30) Priority: 27.09.2023 KR 20230130267; 31.10.2023 KR 20230147807; 24.09.2024 KR 20240128673
(71) Applicant: KMW Inc., Hwaseong-si, Gyeonggi-do 18462 (KR)
(72) Inventor: LEE, Keum Hwan, Busan 49459 (KR); JI, Kyo Sung, Hwaseong-si Gyeonggi-do 18484 (KR); SEO, Jin Kook, Busan 46726 (KR); RYU, Chi Back, Hwaseong-si Gyeonggi-do 18378 (KR); CHOI, Kyu Chul, Osan-si Gyeonggi-do 18151 (KR); KIM, Dong Won, Bucheon-si Gyeonggi-do 14574 (KR); KANG, Hyun Gyu, Osan-si Gyeonggi-do 18114 (KR); CHOI, In Hwa, Yongin-si Gyeonggi-do 17148 (KR)
(74) Representative: impuls legal PartG mbB
(86) International application number: PCT/KR2024/014425
(87) International publication number: WO 2025/071166

(57) **Abstract**

A heat dissipation device according to the present invention comprises: a heat conduction panel on one side; a heat conduction panel on the other side, which is bonded to the one side heat conduction panel and forms a refrigerant flow space that is a space where a refrigerant is filled and phase-changed between the one side heat conduction panel and the other side heat conduction panel; and a sintered body column assembly disposed in the refrigerant flow space, wherein the sintered body column comprises: a plurality of condensation unit sintered body columns disposed at a portion corresponding to the condensation end involved in the condensation of the refrigerant through heat exchange with external air, in the refrigerant flow space; and an evaporation unit sintered body base disposed, in the refrigerant flow space, at the evaporation end that is close to heating elements as the portion excluding the condensation end, and connected to at least one of the plurality of condensation unit sintered body columns, thereby maximizing heat dissipation performance and improving bonding force.

## Description

### [Technical Field]

The present disclosure relates to a heat dissipation apparatus, and more particularly, to a heat dissipation apparatus, which is intended to maximize heat dissipation performance and to improve product productivity.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a cooling system at an appropriate level should be accompanied therewith.

The cooling system is used in various industries, including air conditioners, mobile communications, data centers, air mobility, electric vehicles, energy storage devices, and displays. Such a cooling system is one of the major causes of power consumption, and the power consumption is gradually increasing as industries continue to develop.

In general, a cooling device may be broadly classified into an active cooling device and a passive cooling device. The active cooling device mainly utilizes forced convection generated by a fan, whereas the passive cooling device may be classified as a technology that utilizes natural convection without using a fan.

However, a conventional cooling system has limitations in dissipating a high level of heat generated by continuously developing and advanced technologies. Thus, there is a need in related industrial fields for innovative technologies capable of solving these problems, and as part of efforts to solve them, heat dissipation apparatuses are being developed.

A phase change refers to a change in the inherent state of liquid, gas, or solid when it accumulates a large amount of energy or releases stored thermal energy.

The phase change refers to a change in the physical arrangement of molecules rather than a chemical reaction such as chemical bonding or formation. The heat in a state in which no phase change occurs when energy is applied to a substance is referred to as sensible heat, whereas the heat used during a phase change is referred to as latent heat.

However, the heat dissipation apparatus has a problem in that pressure increases as temperature rises, because temperature and pressure are proportional to each other. When pressure increases due to high temperature conducted from a heating element within the sealed heat dissipation apparatus, it may cause the heat dissipation apparatus itself to rupture. To address this problem, it is necessary to prevent the pressure from increasing, and the heat dissipation apparatus requires a sufficient internal volume to allow pressure equilibrium to be achieved during the phase-change circulation process of a substance.

### [Disclosure]

### [Technical Problem]

The present disclosure is proposed to resolve the aforementioned technical issues and is directed to providing a heat dissipation apparatus that can maximize heat dissipation performance.

In addition, the present disclosure is directed to providing a heat dissipation apparatus that can improve the operational safety of a worker (e.g., an assembler) by removing a sharp portion of an edge portion forming a condensation end.

Technical issues of the present disclosure are not limited to the technical issues mentioned above, and other technical issues not mentioned above will be clearly understood by those skilled in the art from the following description.

### [Technical Solution]

A heat dissipation apparatus according to an embodiment of the present disclosure includes a first-side heat-conducting panel, a second-side heat-conducting panel bonded to the first-side heat-conducting panel and forming, with the first-side heat-conducting panel, a refrigerant flow space in which a refrigerant is filled and undergoes phase change, and a sintered body column assembly disposed on the refrigerant flow space, and the sintered body column assembly includes a plurality of condenser sintered body columns disposed at a portion corresponding to a condensation end that is involved in condensation of the refrigerant through heat exchange with outside air (outdoor air) in the refrigerant flow space, and an evaporator sintered body base disposed at an evaporation end, which is a portion of the refrigerant flow space excluding the condensation end and is closer to heat-generating elements, and connected to at least one of the plurality of condenser sintered body columns.

The first-side heat-conducting panel and the second-side heat-conducting panel may be made of the same metal material having a thermal conductivity equal to or greater than a predetermined value.

The first-side heat-conducting panel and the second-side heat-conducting panel may be provided as metal panel members made of SUS.

The first-side heat-conducting panel and the second-side heat-conducting panel may be sheet-metal processed by a press forming process.

The sintered body column assembly may further include an additional sintered body base connected to the evaporator sintered body base and located at a lower side of the condensation end with respect to a gravity direction, and a lower end of each of the plurality of condenser sintered body columns may be connected to the additional sintered body base.

When the additional sintered body base is arranged to be inclined in a vertical direction along the condensation end, a lower end of the additional sintered body base may be connected so as to contact one side of an upper portion of the evaporator sintered body base while avoiding an upper end of the evaporator sintered body base.

An upper end of the evaporator sintered body base may be positioned at a higher location with respect to a gravity direction than at least an inclined lower end of the additional sintered body base.

A lower end of a condenser sintered body column, disposed close to the evaporator sintered body base, among the plurality of condenser sintered body columns may be connected to the evaporator sintered body base.

The lower end of the condenser sintered body column may be disposed so as to contact one side while avoiding the upper end of the evaporator sintered body bar.

The heat dissipation apparatus may further include a condenser sintered body base arranged to be inclined at the condensation end excluding the evaporation end so as to connect respective lower ends of the plurality of condenser sintered body columns, and an inclined lower end of the condenser sintered body base may be arranged to contact one side of an upper portion of the evaporator sintered body bar.

The upper end of the evaporator sintered body bar may be positioned, at least with respect to the direction of gravity, at a higher position than the inclined lower end of the condenser sintered body base.

The evaporator sintered body bar may be bonded so as to be in surface thermal contact with the evaporation end by a brazing welding method.

The evaporator sintered body bar may include a bonding panel formed by bending a panel made of copper (Cu) to have a 'U'-shaped cross-section with one side open, and a sintered body foam portion formed by sintering powder made of copper (Cu) inside the bonding panel.

Among the sintered body columns, the plurality of condenser sintered body columns and the condenser sintered body base may be formed by sintering metal powder that is the same material as the metal material forming the first-side heat-conducting panel and the second-side heat-conducting panel.

Among the sintered body columns, the evaporator sintered body bar may be formed by sintering metal powder made of copper (Cu).

### [Advantageous Effects]

A heat dissipation apparatus according to an embodiment of the present disclosure can achieve the effect of significantly improving heat dissipation performance and enhancing bonding strength between a first-side heat-conducting panel and a second-side heat-conducting panel.

In addition, the present disclosure can achieve the effect of improving heat dissipation performance by forming a liquid refrigerant retaining end at a condensation end corresponding to a condensation region, thereby more uniformly supplying the liquid refrigerant to an evaporation end side.

### [Description of Drawings]

FIG. 1 is a perspective view illustrating an application example of a heat dissipation apparatus according to the present disclosure;
FIG. 2 is a perspective view illustrating the heat dissipation apparatus according to the present disclosure;
FIGS. 3A and 3B are exploded perspective views of FIG. 2, illustrating exploded perspective views of heat dissipation apparatuses according to one embodiment 200-1 and another embodiment 200-2 of the present disclosure;
FIGS. 4A and 4B are front views illustrating the layout of a sintered body column assembly among components of the heat dissipation apparatuses according to one embodiment 200-1 of the present disclosure and another embodiment 200-2 of the present disclosure, with a first-side heat-conducting panel removed from components of FIG. 2;
FIG. 5 is a front view of FIG. 2;
FIG. 6 is a cross-sectional view taken along line A-A of FIG. 5, illustrating cross-sectional views of the heat dissipation apparatuses according to one embodiment 200-1 and another embodiment 200-2;
FIG. 7 is an enlarged view of portions "B" and "C" of FIG. 6;
FIG. 8 is a cross-sectional view illustrating a bonded state between the first-side heat-conducting panel and a second-side heat-conducting panel among the components of FIG. 2, and a partially enlarged view thereof;
FIG. 9A is a perspective view illustrating an evaporator sintered body base applied to the heat dissipation apparatus according to one embodiment of the present disclosure, and a partially enlarged view thereof, as a part of components of FIG. 4A; and
FIG. 9B is a perspective view illustrating an evaporator sintered body base applied to the heat dissipation apparatus according to another embodiment of the present disclosure, and a partially enlarged view thereof, as a part of components of FIG. 4B.

### <Description of reference numerals>

200: Heat dissipation apparatus (one embodiment) 200A: First-side heat-conducting panel
200B: Second-side heat-conducting panel 200A-P: First-side thickness-forming panel
200B-P: Second-side thickness-forming panel 200-1: Another embodiment
201: Evaporation end 203: Condensation end
204: Liquid refrigerant retaining end 205: Refrigerant flow space
230: Strength reinforcing portion 235: Column support protrusion
250: Sintered body column assembly 251: Condenser sintered body column
255: Evaporator sintered body base 255-1: Additional sintered body base
255B-1: Sintered body foam portion 255B-2: Bonding panel
255A-3, 255B-3: Bonding avoidance cut portions

### [Mode for Invention]

Hereinafter, heat dissipation apparatuses according to embodiments of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

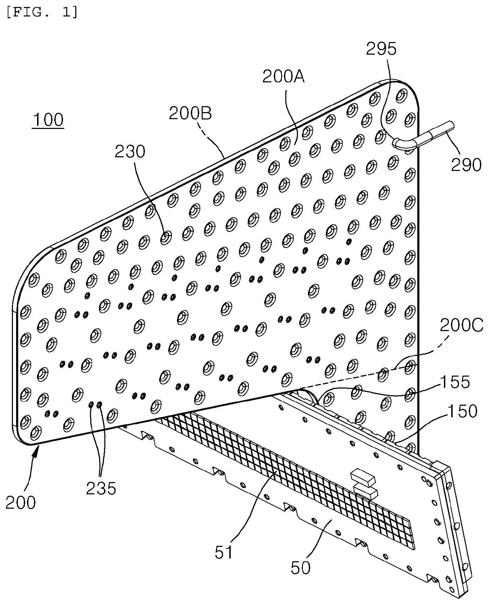

FIG. 1 is a perspective view illustrating an application example of a heat dissipation apparatus according to the present disclosure.

As shown in FIG. 1, a heat dissipation apparatus 200 according to one embodiment of the present disclosure may be configured to receive heat generated from an electronic device 50 (e.g., an LED unit), on which heat-generating devices 51 (e.g. LED devices in a lighting device) as heat dissipation targets are mounted, and to dissipate the heat through heat exchange with outside air (outdoor air).

Here, although the electronic device as the heat dissipation target cooled by the heat dissipation apparatus 200 according to one embodiment of the present disclosure is described as being limited to the LED unit 50 including the LED devices 51, the electronic device is not necessarily limited thereto, and electronic devices related to an antenna device or other similar technical fields, which fall within the principal technical field of the applicant of the present disclosure, are not excluded.

The LED unit 50 transfers and supplies heat generated from the LED devices 51 to the heat dissipation apparatus 200 according to one embodiment of the present disclosure through a rear surface in FIG. 1.

However, in order to facilitate installation on the rear surface of the LED unit 50 and heat transfer to the heat dissipation apparatus 200, a plurality of heat transfer medium blocks 160 may be installed between the LED unit 50 and the heat dissipation apparatus 200, and an evaporation end 201 of the heat dissipation apparatus 200, which will be described later, may be coupled through installation grooves 165 formed between the plurality of heat transfer medium blocks 160 or in the blocks themselves.

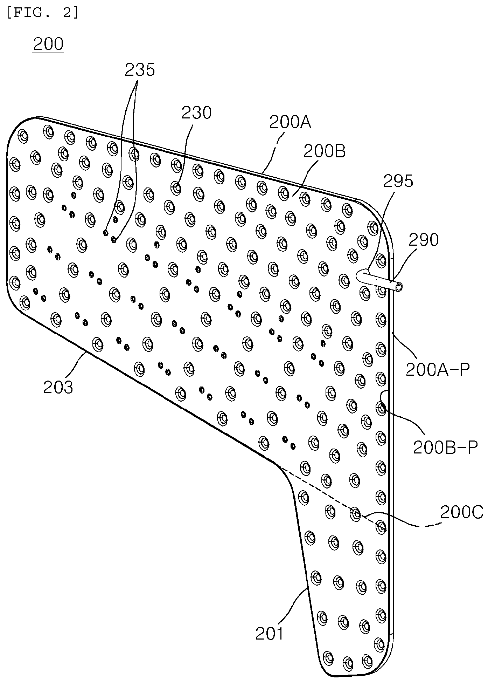

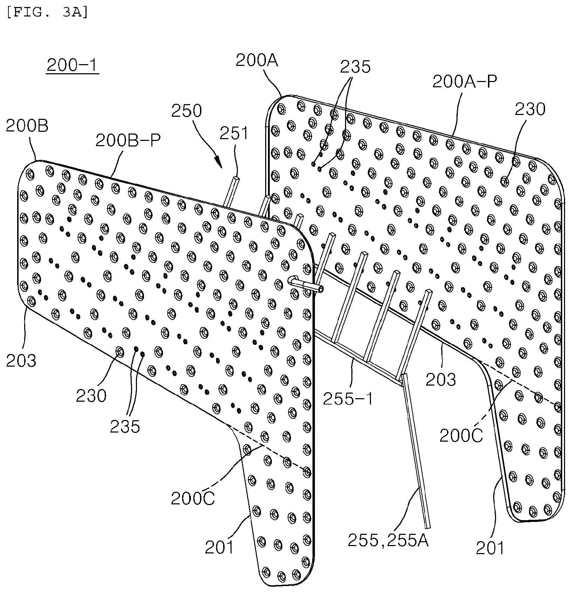

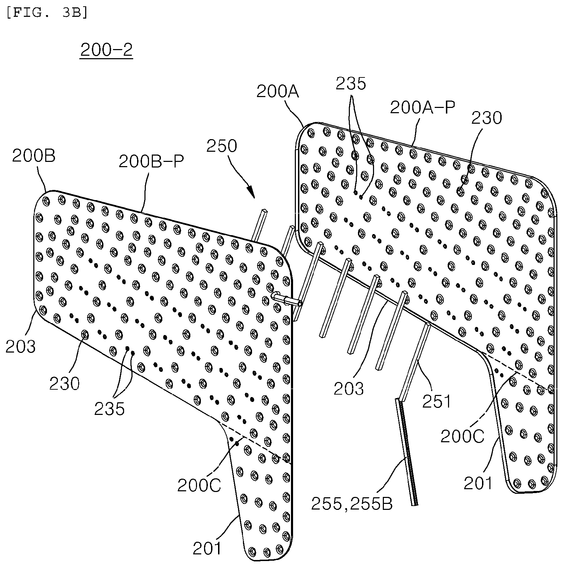

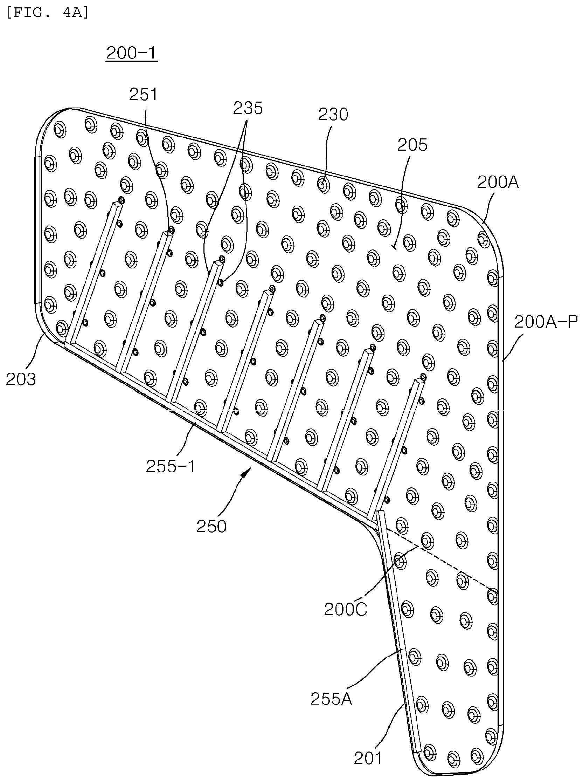

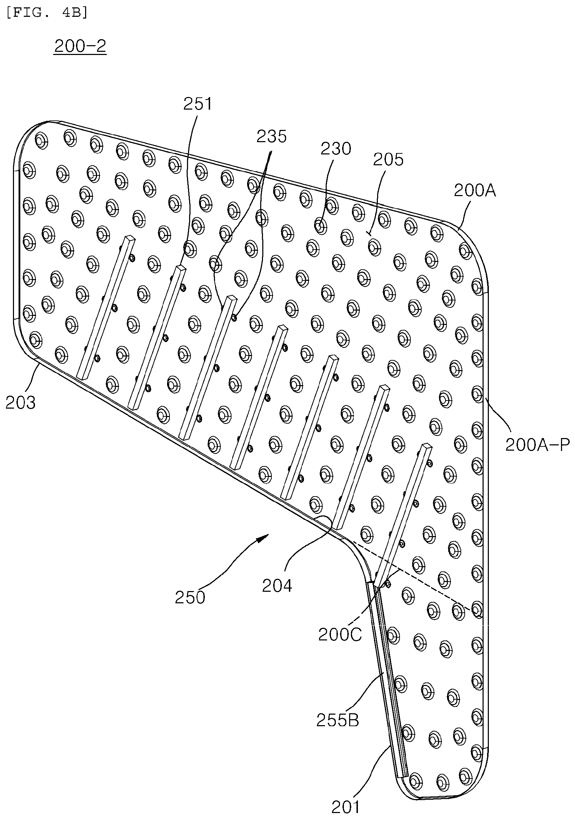

FIG. 2 is a perspective view illustrating the heat dissipation apparatus according to the present disclosure, FIGS. 3A and 3B are exploded perspective views of FIG. 2, illustrating exploded perspective views of heat dissipation apparatuses according to one embodiment 200-1 and another embodiment 200-2 of the present disclosure, and FIGS. 4A and 4B are front views illustrating the layout of a sintered body column assembly among components of the heat dissipation apparatuses according to one embodiment 200-1 of the present disclosure and another embodiment 200-2 of the present disclosure, with a first-side heat-conducting panel removed from components of FIG. 2.

As shown in FIGS. 1 to 4B, the heat dissipation apparatus 200 according to the present disclosure includes a first-side heat-conducting panel 200A provided as a metal panel member, and a second-side heat-conducting panel 200B provided as a metal panel member.

In particular, a portion corresponding to a space between the first-side heat-conducting panel 200A and the second-side heat-conducting panel 200B may form a refrigerant flow space 205 having a sealed (shielded) structure with the outside, as will be described later, and a refrigerant may be filled therein so that the refrigerant may undergo a phase change within the refrigerant flow space 205 by heat supplied from external heat-generating elements (e.g., see reference numeral 51 described later), thereby dissipating system heat. This will be described in greater detail later.

Here, the first-side heat-conducting panel 200A and the second-side heat-conducting panel 200B may be made of the same metal material (metal panel material) having a thermal conductivity equal to or greater than a predetermined level.

Preferably, the panels may be made of at least stainless steel (SUS), which is one of metal materials having a thermal conductivity lower than that of aluminum (Al), so that a phase change of the refrigerant through heat exchange with outside air (outdoor air), particularly a phase change in which the refrigerant condenses from a vapor phase into a liquid phase, may be smoothly performed.

The specific reason for adopting the SUS material as the metal material forming the first-side heat-conducting panel 200A and the second-side heat-conducting panel 200B will be described in more detail later.

In addition, in the heat dissipation apparatus 200 according to a first embodiment of the present disclosure, the first-side heat-conducting panel 200A and the second-side heat-conducting panel 200B may be formed by sheet metal processing using a press forming process.

For reference, although the press forming process is not shown, it may be understood as a process in which a metal base panel made of SUS is subjected to the sheet metal processing through a press forming device so that at least respective edge portions are bonded to each other by a bonding medium frame body 280.

At this time, through the press forming process, not only the outer shapes of the first-side heat-conducting panel 200A and the second-side heat-conducting panel 200B but also a plurality of strength reinforcing portions 230 to be described later, together with a first-side thickness-forming panel 200A-P and a second-side thickness-forming panel 200B-P, which will be described later, may be simultaneously formed.

Here, the first-side heat-conducting panel 200A and the second-side heat-conducting panel 200B may be sheet metal processed products of a metal panel member made of SUS. The thicknesses of the first-side heat-conducting panel 200A and the second-side heat-conducting panel 200B are set to be very thin, and may be set to a thickness not exceeding 0.15t.

In general, among metal materials, aluminum (Al) is well known as the most widely used material in terms of thermal conductivity and weight. Here, when a heat dissipation device itself, which substantially performs a heat dissipation or heat exchange function, has the form of heat sink fins and performs heat transfer solely through the material itself without using a phase-changeable refrigerant as a heat transfer medium as in an embodiment of the present disclosure, it is natural that aluminum be adopted as an optimal material.

That is, since aluminum has a very excellent thermal conductivity of 230 and has a low specific gravity, it is one of the most widely adopted materials as a heat dissipation element.

However, although aluminum has thermal conductivity and specific gravity superior to those of SUS, which is the material of the first-side heat-conducting panel 200A and second-side heat-conducting panel 200B adopted in one embodiment of the present disclosure (in fact, the thermal conductivity of SUS is 20), aluminum is relatively expensive in terms of cost, and when a refrigerant is filled therein, the type of refrigerant that may be filled is very limited.

For example, when distilled water (water) is adopted as the refrigerant, a chemical reaction occurs in the case of aluminum, making it impossible for the distilled water to function as the refrigerant, and thus there has been a problem in that distilled water should be excluded from the selectable refrigerant.

In order to solve the problems of aluminum, in the heat dissipation apparatus 200 or 200-1 according to one embodiment of the present disclosure, the metal material of the first-side heat-conducting panel 200A and second-side heat-conducting panel 200B uses SUS that hardly causes a chemical reaction with distilled water.

The first-side heat-conducting panel 200A and the second-side heat-conducting panel 200B may be surface-bonded at edge portions thereof to each other to form the refrigerant flow space 205, in which the refrigerant undergoes a phase change and flows.

Here, the first-side heat-conducting panel 200A and the second-side heat-conducting panel 200B may be bonded to each other along respective edge portions so that the above-described refrigerant flow space 205 is defined therein.

However, as described above, when edge portions of two metal panel members each having a very thin thickness (0.15T) are joined to form the first-side heat-conducting panel 200A and the second-side heat-conducting panel 200B, the joined edge portions have a thickness of 0.3T and may have very sharp edges unless additional processing is performed, thereby posing a risk that a worker may be injured during work.

In order to minimize injury to a worker (installer) during such work, one of the first-side heat-conducting panel 200A and the second-side heat-conducting panel 200B may be bonded so as to be inserted into the other, as shown in FIGS. 1 to 3.

More specifically, as shown in FIGS. 3A and 3B, both the first-side heat-conducting panel 200A and the second-side heat-conducting panel 200B are formed such that their edge portions (see 200A-P and 200B-P) are bent, and each bent edge portion forms the first-side thickness-forming panel 200A-P and the second-side thickness-forming panel 200B-P. A portion of the first-side thickness-forming panel 200A-P of the first-side heat-conducting panel 200A and a portion of the second-side thickness-forming panel 200B-P of the second-side heat-conducting panel 200B may be disposed to overlap in a thickness direction of the refrigerant flow space 205.

Here, the first-side thickness-forming panel 200A-P is a portion bent along the edge portion of the first-side heat-conducting panel 200A and may be bent to extend substantially perpendicular toward the second-side heat-conducting panel 200B, while the second-side thickness-forming panel 200B-P is a portion bent along the edge portion of the second-side heat-conducting panel 200B and may be bent to extend substantially perpendicular toward the first-side heat-conducting panel 200A.

As such, the edge portion of the first-side heat-conducting panel 200A and the edge portion of the second-side heat-conducting panel 200B may be respectively bent in a direction forming the thickness of the refrigerant flow space 205, thereby forming the above-described first-side thickness-forming panel 200A-P and second-side thickness-forming panel 200B-P.

At this time, the second-side thickness-forming panel 200B-P of the second-side heat-conducting panel 200B may be inserted into the first-side thickness-forming panel 200A-P of the first-side heat-conducting panel 200A, such that at least a front end of the second-side thickness-forming panel 200B-P may be bonded to be concealed from the outside by the first-side thickness-forming panel 200A-P of the first-side heat-conducting panel 200A.

As such, the first-side thickness-forming panel 200A-P of the first-side heat-conducting panel 200A functions as a thickness-forming panel that forms the overall thickness of the refrigerant flow space 205. Thus, the thickness of the edge portion is formed to be sufficiently greater than at least the sum of the material thicknesses of the first-side heat-conducting panel 200A and the second-side heat-conducting panel 200B, thereby providing an additional function of preventing injuries to a worker (including an assembler) by eliminating sharp edge portions during work.

Inside a space between the first-side heat-conducting panel 200A and the second-side heat-conducting panel 200B bonded to each other, the refrigerant flow space 205 is formed in which refrigerant is filled and flows while undergoing phase change, and the refrigerant flow space may be in surface thermal contact with the heat-generating elements (e.g., the LED devices 51 mounted on an LED board 50 of the lighting device 100 of FIG. 1) that supply heat to the filled refrigerant.

That is, the heat dissipation apparatus 200 or 200-1 according to the present disclosure will be described with reference to FIG. 1 by illustrating, as a representative example of the heat dissipation target among electronic devices (electronic products), the LED devices 51 mounted on the LED board 50 of the lighting device 100.

However, the electronic device which is the heat dissipation target cooled by the heat dissipation apparatus 200 or 200-1 according to the present disclosure is not limited to the lighting device 100, and it should be understood as a concept including all electronic devices related to antenna devices, which correspond to principal products manufactured and sold by the applicant of the present disclosure, or other similar technical fields.

The LED devices 50 may transfer and supply heat generated therefrom to the heat dissipation apparatus 200 or 200-1 according to the present disclosure through the rear surface of the LED board 50.

The refrigerant filled in the refrigerant flow space 205 corresponds to a phase change material that may undergo phase change by heat supplied from the heat-generating elements 51 (the LED devices) or through heat exchange with outside air (outdoor air). In particular, the refrigerant used herein is preferably distilled water (water), which does not cause environmental pollution, when the metal material forming the first-side heat-conducting panel 200A and the second-side heat-conducting panel 200B excludes aluminum (Al).

Hereinafter, among the edge portions of the heat dissipation apparatus 200 according to one embodiment of the present disclosure, in which the first-side heat-conducting panel 200A and the second-side heat-conducting panel 200B are bonded, a portion that receives heat from the heat-generating elements (LED devices) 51 is defined as an evaporation end 201, and all remaining portions except for the evaporation end 201 are defined as a condensation end 203.

More specifically, the refrigerant flow space 205 may be understood such that a portion corresponding to a relatively lower position in a gravity direction serves as a region (evaporation region) where liquid refrigerant is stored and evaporates into vapor refrigerant upon receiving heat, and a portion corresponding to a relatively upper position in the gravity direction serves as a region (condensation region) where vapor refrigerant actively flows and is condensed into liquid refrigerant through heat exchange with outside air (outdoor air).

Hereinafter, the evaporation region and the condensation region will be understood as being distinguished based on a dotted line denoted by reference numeral 200C in FIG. 2. It will be understood that most of the liquid refrigerant is stored below the dotted line 200C due to gravity, while the vapor refrigerant, once it undergoes phase change from the liquid refrigerant, flows and diffuses to all portions of the refrigerant flow space 205 including the evaporation region, regardless of the dotted line 200C.

Further, a portion corresponding to a lower side in the gravity direction with respect to reference numeral 200C is defined as the evaporation region, that is, the evaporation end 201, and a portion corresponding to an upper side in the gravity direction with respect to reference numeral 200C is defined as the condensation region, that is, the condensation end 203.

However, it is to be noted that reference numeral 200C may not serve as a complete physical boundary for distinguishing the above-described evaporation region and condensation region, condensation may occur even within the evaporation region depending on the properties (and specifications) of the refrigerant, and similarly evaporation may also occur within the condensation region.

Meanwhile, the heat dissipation apparatus 200 according to one embodiment of the present disclosure may further include a sintered body column assembly 250 disposed on the refrigerant flow space 205, as shown in FIGS. 1 to 4B.

Here, the sintered body column assembly 250 may include a plurality of condenser sintered body columns 251 arranged to be spaced apart from each other within the condensation region corresponding to the condensation end 203, and an evaporator sintered body base 255 arranged in the evaporation region corresponding to the evaporation end 201 and connected to at least one 251-1 of the plurality of condenser sintered body columns 251.

In addition, the sintered body column assembly 250 may further include an additional sintered body base 255-1 disposed at the condensation end 203 corresponding to the condensation region and connecting lower ends of the plurality of condenser sintered body columns 251.

However, as shown in FIGS. 3A and 4A and FIGS. 3B and 4B, the liquid refrigerant (condensed refrigerant), the flow of which is guided through the plurality of condenser sintered body columns 251 at the condensation end 203 corresponding to the condensation region, may serve as a criterion for distinguishing one embodiment of the present disclosure (FIGS. 3A and 4A) from another embodiment (FIGS. 3B and 4B), in that the specific arrangement relationship and configuration of the evaporator sintered body base 255 for designing a liquid refrigerant retaining end 204, which will be described later, may vary depending on the presence or absence of the additional sintered body base 255-1 that mediates the transfer to the evaporator sintered body base 255 adjacent to the evaporation end 201 corresponding to the evaporation region. This will be described in greater detail later.

When the plurality of condenser sintered body columns 251 are arranged such that the liquid refrigerant condensed in the condensation region corresponding to the condensation end 203 naturally flows downward due to gravity, they may be vertically or obliquely arranged such that upper ends thereof are positioned on an upper side with respect to the gravity direction and lower ends thereof are positioned on a lower side with respect to the gravity direction.

In addition, as shown in FIGS. 3A and 4A, an additional sintered body base 255-1 included in the heat dissipation apparatus 200-1 according to one embodiment of the present disclosure may serve to allow the liquid refrigerant condensed and guided downward in the gravity direction through the plurality of condenser sintered body columns 251 described above to be easily and uniformly collected in the evaporation region corresponding to the evaporation end 201.

However, as shown in FIGS. 3B and 4B, the heat dissipation apparatus 200-2 according to another embodiment of the present disclosure is not provided with the additional sintered body base 255-1. Thus, the liquid refrigerant flowing down through the plurality of condenser sintered body columns 251 flows along an inclined end corresponding to the condensation end 203 located relatively on the lower side in the gravity direction, and then moves to the evaporation region corresponding to the evaporation end 201 where the evaporator sintered body base 255 is provided, thereby being stored (accumulated).

Hereinafter, in order to facilitate understanding of the heat dissipation apparatus 200 according to the present disclosure, a portion of the condensation region in which the additional sintered body base 255-1 is disposed in the case of one embodiment 200 of the present disclosure, and a portion of the edge portion that is inclined toward the evaporation end 201 as a partial region of the condensation end 203 in the case of another embodiment 200-2 of the present disclosure, will be defined as the liquid refrigerant retaining end 204 and described.

The liquid refrigerant retaining end 204 does not substantially correspond to the evaporation region in which the liquid refrigerant undergoes a phase change into vapor refrigerant. However, it may perform a function of allowing the liquid refrigerant, whose flow is guided through the plurality of condenser sintered body columns 251 described above at the condensation end 203 corresponding to the condensation region, to be retained for as long as possible and then to flow in a uniform amount toward the evaporator sintered body base 255 of the evaporation end 201.

The evaporator sintered body base 255 is installed at the evaporation end 201, which is substantially closest to the heat-generating elements 51 (LED devices) in the evaporation region, and serves to directly receive heat from the heat-generating elements 51 (LED devices), thereby evaporating the liquid refrigerant.

That is, the evaporator sintered body base 255 is configured to be bonded to the evaporation end 201, which substantially receives heat from the heat-generating elements 51 (LED devices), by a brazing welding bonding method so as to be in surface thermal contact therewith, thereby performing a function of causing the liquid refrigerant stored in the refrigerant flow space 205 to undergo a phase change into vapor refrigerant.

However, although it is preferable that the liquid refrigerant be stored (accumulated) throughout the entire evaporation region including the evaporation end 201 (particularly up to a level exceeding 200C shown by the dotted line), the level of the liquid refrigerant may be positioned lower than the upper end of the evaporator sintered body base 255 depending on changes in the installation position of the heat dissipation apparatus 200 according to the present disclosure. In this case, substantially, the liquid refrigerant may not be uniformly evaporated over the entire area of the evaporator sintered body base 255.

Therefore, the purpose of providing the above-described liquid refrigerant retaining end 204 is to supply a uniform amount of liquid refrigerant to the evaporator sintered body base 255.

Here, the sintered body column assembly 250 may be formed by sintering powder entirely made of SUS, and the evaporator sintered body base 255 disposed closer to the evaporation end 201 may be formed of a sintered body made of Cu (copper), in that a higher thermal conductivity is required to evaporate the liquid refrigerant in the refrigerant flow space 205 into vapor refrigerant.

More specifically, the plurality of condenser sintered body columns 251 or the additional sintered body base 255-1 disposed at the condensation end 203 corresponding to the condensation region in the sintered body column assembly 250 may be formed by sintering metal powder of the same material as the metal panel members of the first-side heat-conducting panel 200A and the second-side heat-conducting panel 200B.

Therefore, as already described, the materials of the plurality of condenser sintered body columns 251 or the additional sintered body base 255-1 may be understood as being formed by sintering metal powder of SUS so as to have the same thermal conductivity, when it is understood that the first-side heat-conducting panel 200A and the second-side heat-conducting panel 200B are provided as metal panel members made of SUS, although their forming or processing methods may be somewhat different.

However, the evaporator sintered body base 255 disposed closer to the evaporation end 201 substantially requires a high thermal conductivity sufficient to cause the liquid refrigerant to undergo a phase change into vapor refrigerant by the heat supplied from the heat-generating elements 51 (LED devices). Therefore, as described above, it may be formed as a sintered body obtained by sintering metal powder of Cu (copper), which has a higher thermal conductivity than SUS.

Here, the effective arrangement relationship of the sintered body column assembly 250 for maximizing the function of the above-described liquid refrigerant retaining end 204 will be described as follows.

First, as shown in FIGS. 3A and 4A, the plurality of condenser sintered body columns 251 in the sintered body column assembly 250 may be arranged vertically or obliquely such that the liquid refrigerant condensed on the entire heat dissipation surface of the condensation end 203 corresponding to the condensation region from approximately the upper end to the lower end is uniformly distributed and its flow is guided and transferred toward the liquid refrigerant retaining end 204 positioned relatively lower with respect to the gravity direction.

Here, in the case of the heat dissipation apparatus 200 according to one embodiment of the present disclosure in which the additional sintered body base 255-1 connecting the lower ends of the plurality of condenser sintered body columns 251 is disposed to be inclined to one side at the liquid refrigerant retaining end 204, the inclined lower end of the additional sintered body base 255-1 may be arranged to avoid the upper end of the evaporator sintered body base 255 and to contact one side of the upper portion thereof.

At this time, the upper end of the evaporator sintered body base 255 is positioned at a higher location with respect to the gravity direction than at least the inclined lower end of the additional sintered body base 255-1, thereby performing the function of a wall to retain a greater amount of the liquid refrigerant whose flow is guided in the inclined direction along the additional sintered body base 255-1.

More preferably, the upper end of the evaporator sintered body base 255 may be set to be positioned higher than the lower end of the condenser sintered body column 251 that is most closely connected to the inclined lower end of the additional sintered body base 255-1.

Thus, except for the condensed refrigerant (liquid refrigerant) that moves directly downward toward the evaporation end 201 on the right side in FIGS. 3A and 4A after passing over the upper end of the condenser sintered body column 251 most closely connected to the inclined lower end of the additional sintered body base 255-1, most of the condensed refrigerant (liquid refrigerant) may be retained for a longer period through the plurality of condenser sintered body columns 251 or the additional sintered body base 255-1 and then supplied uniformly toward the evaporation end 201.

Next, as shown in FIGS. 3B and 4B illustrating an embodiment in which the additional sintered body base 255-1 is not provided in the region corresponding to the liquid refrigerant retaining end 204, in the case of the heat dissipation apparatus 200-2 according to another embodiment of the present disclosure, the upper end of the evaporator sintered body base 255 and the lower end of the condenser sintered body column 251 located closest to the evaporation end 201 corresponding to the evaporation region among the plurality of condenser sintered body columns 251 may be arranged to be connected to each other.

At this time, it is preferable that the lower end of the condenser sintered body column 251 be arranged to contact (be connected to) one side while avoiding the upper end of the evaporator sintered body base 255.

That is, the lower end of the condenser sintered body column 251 may be connected so as to contact one side of the upper portion of the evaporator sintered body base 255 while exposing the upper end of the evaporator sintered body base 255 upward with respect to the gravity direction.

As such, since the lower end of the condenser sintered body column 251 is connected so as to avoid the upper end of the evaporator sintered body base 255, the liquid refrigerant retained in the liquid refrigerant retaining end 204 may be absorbed through the upper portion of the evaporator sintered body base 255.

Thus, except for the condensed refrigerant (liquid refrigerant) that moves directly downward toward the evaporation end 201 on the right side in FIGS. 3B and 4B after passing over the upper end of the condenser sintered body column 251 directly connected to the upper portion of the evaporator sintered body base 255, most of the condensed refrigerant (liquid refrigerant) is uniformly collected at the liquid refrigerant retaining end 204 through the plurality of condenser sintered body columns 251, retained for a longer period of time, and then supplied to the evaporator sintered body base 255 on the evaporation end 201.

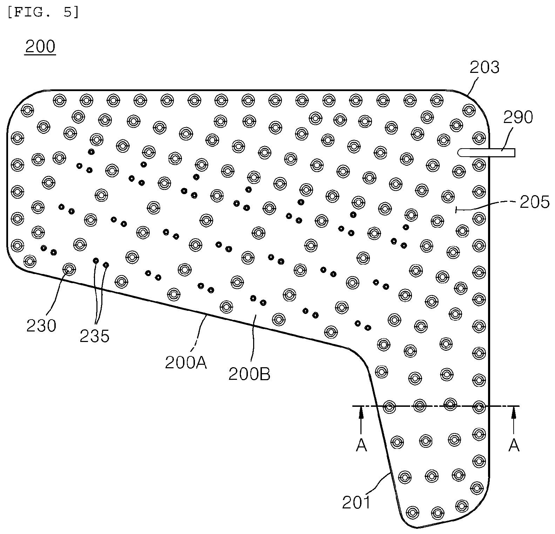

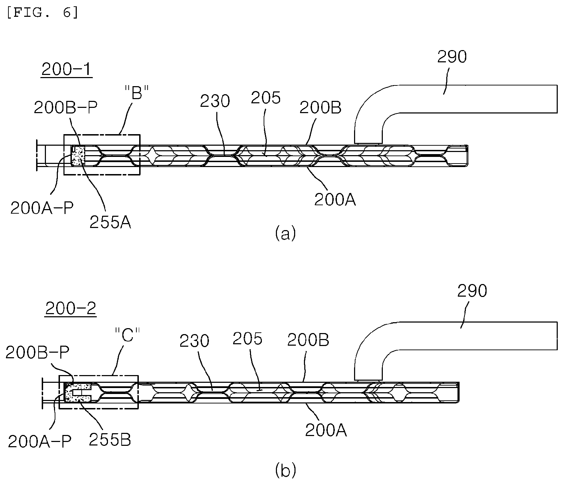

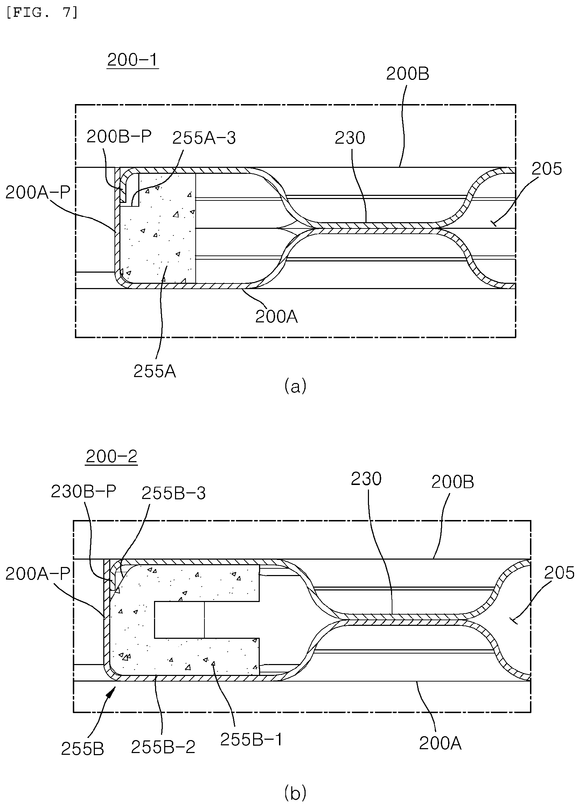

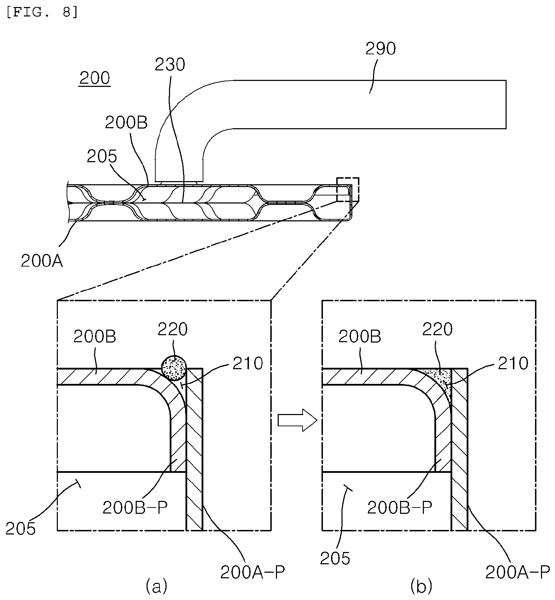

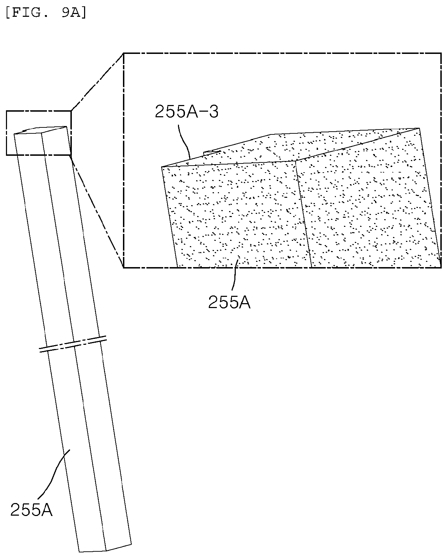

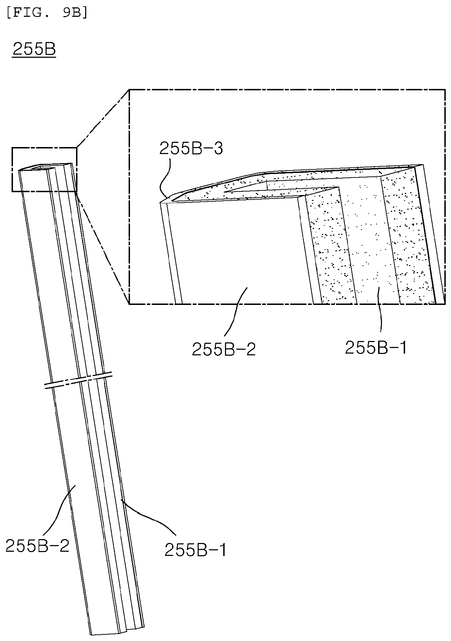

FIG. 5 is a front view of FIG. 2, FIG. 6 is a cross-sectional view taken along line A-A of FIG. 5, illustrating cross-sectional views of the heat dissipation apparatuses according to one embodiment 200-1 and another embodiment 200-2, FIG. 7 is an enlarged view of portions "B" and "C" of FIG. 6, FIG. 8 is a cross-sectional view illustrating a bonded state between the first-side heat-conducting panel and the second-side heat-conducting panel among the components of FIG. 2, and a partially enlarged view thereof, FIG. 9A is a perspective view illustrating the evaporator sintered body base applied to the heat dissipation apparatus according to one embodiment of the present disclosure, and a partially enlarged view thereof, as a part of components of FIG. 4A, and FIG. 9B is a perspective view illustrating the evaporator sintered body base applied to the heat dissipation apparatus according to another embodiment of the present disclosure, and a partially enlarged view thereof, as a part of components of FIG. 4B.

In the heat dissipation apparatus 200 according to the present disclosure, as shown in FIGS. 5 to 9, the first-side heat-conducting panel 200A and the second-side heat-conducting panel 200B may each further include a plurality of strength reinforcing portions 230 that are sheet-metal processed to be recessed toward the refrigerant flow space 205 during a press forming process, and column support protrusions 235 that support installation of the sintered body column assembly 250.

The plurality of strength reinforcing portions 230 not only serve to reinforce the inherent strength of the first-side heat-conducting panel 200A and the second-side heat-conducting panel 200B formed with very thin thicknesses, but may also perform a function of actively responding to internal pressure changes generated during phase change of the refrigerant by welding portions that contact each other within the refrigerant flow space 205.

Meanwhile, in the heat dissipation apparatus 200 or 200-1 according to embodiments of the present disclosure, during the bonding process of the first-side heat-conducting panel 200A and the second-side heat-conducting panel 200B, as will be described later, the refrigerant flow space 205 is bonded so as to be completely shielded (sealed) from the outside by using a filler material application gap 210 formed to enable welding bonding using a filler material 220.

As shown in FIGS. 6 and 8, the bonding process using the filler material application gap 210 formed by the first-side thickness-forming panel 200A-P of the first-side heat-conducting panel 200A and the second-side thickness-forming panel 200B-P of the second-side heat-conducting panel 200B, and the filler material 220 applied thereto, will be described in more detail as follows.

In the heat dissipation apparatus 200 according to the present disclosure, as shown in FIGS. 6 and 8, a portion corresponding to the edge portion of the second-side heat-conducting panel 200B, namely, a rounded outer surface of the second-side thickness-forming panel 200B-P, which will be described later, and a portion corresponding to the edge portion of the first-side heat-conducting panel 200A, namely, the front end of the first-side thickness-forming panel 200A-P may be bonded by a filler material 220 applied in a filler material application gap 210 defined therebetween.

In order to form the filler material application gap 210 as described above, the outer surface of the second-side heat-conducting panel 200B and the front end of the first-side thickness-forming panel 200A-P of the first-side heat-conducting panel 200A may be formed to match each other.

More specifically, the second-side thickness-forming panel 200B-P of the second-side heat-conducting panel 200B may be formed to be rounded and bent with a predetermined radius with respect to the outer surface of the second-side heat-conducting panel 200B such that the above-described filler material application gap 210 is formed between the second-side thickness-forming panel and the front end of the first-side thickness-forming panel 200A-P of the first-side heat-conducting panel 200A.

Here, the filler material application gap 210 may be defined as a gap between the front end of the first-side thickness-forming panel 200A-P, which is bent perpendicularly to the outer surface of the first-side heat-conducting panel 200A, and the rounded outer surface of the second-side heat-conducting panel 200B.

When the second-side heat-conducting panel 200B is installed so as to be inserted in to the first-side heat-conducting panel 200A, as shown in FIGS. 5 and 6, the filler material application gap 210, to which the filler material 220 may be applied, is naturally formed between the rounded outer surface of the second-side thickness-forming panel 200B-P of the second-side heat-conducting panel 200B and the front end of the first-side thickness-forming panel 200A-P of the first-side heat-conducting panel 200A. After the filler material 220 is applied, the filler material 220 is melted and permeated by a brazing welding process and then hardened, thereby bonding the first-side heat-conducting panel 200A and the second-side heat-conducting panel 200B.

Meanwhile, as shown in FIGS. 6 and 7, the installation process of the evaporator sintered body base 255A or 255B with respect to the evaporation end 201 corresponding to the evaporation region will be briefly described as follows.

That is, the evaporator sintered body base 255 is formed as a sintered body made of Cu (copper) as described above and is coupled so as to be in surface thermal contact with the evaporation end 201 by a brazing welding coupling method. However, when the brazing welding coupling method is applied, there is a concern that it may affect the formation of a plurality of pores, which are fine holes that should be formed in the sintered body itself.

However, as described above, if a coupling method that does not cause any concern in the process of forming the plurality of pores in the sintered body itself is applied, it will not pose a significant problem. Thus, as shown in (a) of FIG. 7, it may also be possible to directly bond the evaporator sintered body base 255A to the evaporation end 201.

However, as shown in (b) of FIG. 7 and FIG. 9B, when the evaporator sintered body base 255B may affect the formation of the plurality of pores due to the application of the brazing welding coupling method, the evaporator sintered body base 255B may include a sintered body foam portion 255B-1 formed by sintering copper (Cu) powder and a bonding panel 255B-2 formed by bending a thin Cu panel to have a 'U'-shaped cross-section with one side open, and the sintered body foam portion 255B-1 may be sintered and formed in a state where it is inserted into the bonding panel 255B-2.

Here, the bonding panel 255B-2 substantially serves as a bonding portion with respect to the inner side of the evaporation end 201, and prevents the plurality of pores from being melted and damaged by heat transferred through the brazing welding coupling method, thereby increasing the bonding strength and preventing damage to the plurality of pores that are directly involved in the phase change of the liquid refrigerant.

Meanwhile, in the evaporator sintered body bases 255A and 255B, bonding avoidance cut portions 255A-3 and 255B-3 may be formed to avoid bonding with the second-side thickness-forming panel 200B-P of the second-side heat-conducting panel 200B described above.

Such bonding avoidance cut portions 255A-3 and 255B-3 are provided by cutting in a chamfered shape portions, where heat transfer to the evaporator sintered body bases 255A and 255B is expected during application and welding of the filler material 220 through the above-described filler material application gap 210, thereby preventing unnecessary thermal deformation and also serving to easily receive the second-side thickness-forming panel 200B-P of the second-side heat-conducting panel 200B that is inserted into the first-side heat-conducting panel 200A.

As described above, heat dissipation apparatuses according to embodiments of the present disclosure has been described in detail with reference to the accompanying drawings. However, embodiments of the present disclosure are not necessarily limited to the above-described embodiment, and it will be apparent that various modifications and equivalent implementations are possible by those skilled in the art. Therefore, the true scope of the present disclosure is defined by the claims set forth below.

### [Industrial Applicability]

The present disclosure provides a heat dissipation apparatus, in which heat dissipation performance can be maximized and bonding strength between panels can be improved.

## Claims

1. A heat dissipation apparatus comprising:
a first-side heat-conducting panel;
a second-side heat-conducting panel bonded to the first-side heat-conducting panel and forming, with the first-side heat-conducting panel, a refrigerant flow space in which a refrigerant is filled and undergoes phase change; and
a sintered body column assembly disposed on the refrigerant flow space,
wherein the sintered body column assembly comprises:
a plurality of condenser sintered body columns disposed at a portion corresponding to a condensation end that is involved in condensation of the refrigerant through heat exchange with outside air (outdoor air) in the refrigerant flow space; and
an evaporator sintered body base disposed at an evaporation end, which is a portion of the refrigerant flow space excluding the condensation end and is closer to heat-generating elements, and connected to at least one of the plurality of condenser sintered body columns.

2. The heat dissipation apparatus of claim 1, wherein the first-side heat-conducting panel and the second-side heat-conducting panel are made of the same metal material having a thermal conductivity equal to or greater than a predetermined value.

3. The heat dissipation apparatus of claim 1, wherein the first-side heat-conducting panel and the second-side heat-conducting panel are provided as metal panel members made of SUS.

4. The heat dissipation apparatus of claim 1, wherein the first-side heat-conducting panel and the second-side heat-conducting panel are sheet-metal processed by a press forming process.

5. The heat dissipation apparatus of claim 1,
wherein the sintered body column assembly further comprises an additional sintered body base connected to the evaporator sintered body base and located at a lower side of the condensation end with respect to a gravity direction, and
wherein a lower end of each of the plurality of condenser sintered body columns is connected to the additional sintered body base.

6. The heat dissipation apparatus of claim 5, wherein, when the additional sintered body base is arranged to be inclined in a vertical direction along the condensation end,
a lower end of the additional sintered body base is connected so as to contact one side of an upper portion of the evaporator sintered body base while avoiding an upper end of the evaporator sintered body base.

7. The heat dissipation apparatus of claim 6, wherein an upper end of the evaporator sintered body base is positioned at a higher location with respect to a gravity direction than at least an inclined lower end of the additional sintered body base.

8. The heat dissipation apparatus of claim 1, wherein a lower end of a condenser sintered body column, disposed close to the evaporator sintered body base, among the plurality of condenser sintered body columns is connected to the evaporator sintered body base.

9. The heat dissipation apparatus of claim 8, wherein the lower end of the condenser sintered body column is connected so as to contact one side while avoiding the upper end of the evaporator sintered body base.

10. The heat dissipation apparatus of claim 9, wherein the lower end of the condenser sintered body column is connected so as to contact one side of an upper portion of the evaporator sintered body base while exposing the upper end of the evaporator sintered body base upward with respect to the gravity direction.

11. The heat dissipation apparatus of claim 1, wherein the evaporator sintered body base is bonded so as to be in surface thermal contact with the evaporation end.

12. The heat dissipation apparatus of claim 11, wherein the evaporator sintered body base is bonded to the evaporation end by a brazing welding bonding method.

13. The heat dissipation apparatus of claim 11 or 12, wherein the evaporation end to which the evaporator sintered body base is bonded is set as an inner surface of the first-side thickness-forming panel that is bent to one side from an edge portion of the first-side heat-conducting panel to form a thickness of the refrigerant flow space.

14. The heat dissipation apparatus of claim 13, wherein the evaporator sintered body base is provided with a bonding avoidance cut portion formed in a chamfered shape to avoid bonding with the second-side thickness-forming panel, which is bent so as to be bonded to the inner surface of the first-side thickness-forming panel.

15. The heat dissipation apparatus of claim 12, wherein the evaporator sintered body base comprises:
a bonding panel formed by bending a panel made of copper (Cu) to have a 'U'-shaped cross-section with one side open; and
a sintered body foam portion formed by sintering powder made of copper (Cu) inside the bonding panel.

16. The heat dissipation apparatus of claim 5, wherein, in the sintered body column assembly, the plurality of condenser sintered body columns and the additional sintered body base are formed by sintering metal powder made of SUS that is the same as the metal material forming the first-side heat-conducting panel and the second-side heat-conducting panel.

17. The heat dissipation apparatus of claim 5, wherein, in the sintered body column assembly, the evaporator sintered body base is formed by sintering metal powder made of copper (Cu).
